# EUROPEAN PATENT APPLICATION

(11) **EP 4 703 802 A1**
(43) Date of publication of application: **04.03.2026**
(21) Application number: 24196677.9
(22) Date of filing: 27.08.2024
(51) Int. Cl.: G03F 7/30

(54) **PROCESSING APPARATUS AND PROCESSING METHOD FOR FLEXOGRAPHIC PRINTING PLATES**

(71) Applicant: ECO3 BV, 2640 Mortsel (BE)
(72) Inventor: Meuris, Werner, 2640 Mortsel (BE); Sinnesael, Jan, 2640 Mortsel (BE); Carbonini, Marcello, 25025 Manerbio (IT); Carbonini, Roberto, 25025 Manerbio (IT); Billiet, Thomas, 2640 Mortsel (BE)
(74) Representative: De Clercq & Partners

(57) **Abstract**

A processing apparatus for processing a photosensitive flexographic printing plate precursor is disclosed which includes a novel and improved filter system and allows continuous processing by re-using used processing solution without requiring frequent user intervention to replace clogged filter material. The filter system includes three tanks in a cascade configuration whereby the solution in the third tank can suitably be used for rinsing the processed plate so that no separate rinsing station is required.

## Description

### Technical Field

This invention relates to the field of flexographic printing, and more particularly to a processing apparatus for flexographic printing plates.

### Background Art

Relief printing plates are plates having image areas raised above non printing areas. Generally, the plate is somewhat soft, and flexible enough to wrap around a printing cylinder, and is durable enough to print many copies. Flexography is commonly used for high-volume runs and employed for printing on a variety of substrates such as for example paper, paperboard, corrugated board, films, foils and laminates. Especially for printing on coarse surfaces and stretch films, flexography is of interest.

Many methods for making relief images are known in the graphic arts. For example, photosensitive materials comprising an ablatable or mask layer on the surface of a photosensitive layer, a so-called "integral mask" or "in-situ mask" whereby relief images are formed by first image-wise exposing the photosensitive material with laser radiation to selectively remove the layer in the exposed areas, i.e. forming a mask, followed by overall exposure with actinic radiation to cure the photosensitive layer in the unmasked areas. Alternative methods include making an article bearing a relief image by first forming a mask image on a base material, for example by thermally imaging a suitable mask film or masking element to provide the desired pattern, followed by transferring the mask image to a photosensitive material, and exposing the assembly to curing radiation, typically ultraviolet radiation.

The exposed regions of the photosensitive material harden or cure and become insoluble in clean out or developing liquids while the unexposed regions remain removable. The cured portions which remain on the photosensitive printing plate define the printing areas while the non-hardened portions are washed away by one or more liquid development processes, for example aqueous or solvent processing. Aqueous-processable flexographic printing plates have gained significant market interest in recent years due to their limited impact on the environment. Nevertheless, there are numerous challenges for aqueous processing that need to be addressed to ensure optimal performance of the printing plates.

In general, an exposed flexographic plate is washed by means of a continuous flow of fresh, clean optionally heated washout liquid (processing liquid). The washout liquid is usually supplied to the surface of the plate through spray bars which are part of a washout brush which brushes the surface of the plate. The washout liquid is preferably re-used after cleaning and/or filtering before it is disposed to waste. Filtration may be carried out by means of a unit including e.g. a removable liner or filter bag. Filtration may also be based on gravitation or centrifugal forces. The size of the filters is limited and clogging often occurs after a relatively short period of time due to the presence of larger debris particles in the washout liquid. Replacement of the filters (liner) is a messy process. For example, after processing a number of printing plates, photopolymers build up in the used processing solution causing various problems such as decreasing the speed of development and/or formation of scum which may adhere to the plates and the brushes. Methods of washing-out photopolymer plates in a washout station are well-known in the art.

US 6,247, 856 describes that after processing a number of printing plates, photopolymers can build up in the used processing solution causing various problems such as decreasing the speed of development and/or formation of scum which adheres to the plates and the brush. In order to avoid frequent disposal of the used developer solution, US 6,247, 856 teaches to remove only a part of the used developer and to add fresh processing solution to keep the resin content of the processing solution substantially constant.

US 2009/0013888 and WO2018/005127 disclose a rinsing station after a processing station in order to remove debris that may be attached to the surface of the printing plate after the processing step. Both used processing solution and rinse water are recycled back to the processor after filtration.

US 2023/0086975 discloses a rotary filter which is precoated with a precoat layer formed by organic and/or mineral compounds having filtering and/or absorbing properties. The precoat is formed on the surface of the rotary filter in the vessel designed for the filtration.

EP 4 147 094 discloses a processing apparatus including a prewash section, a main wash section and a cleaning section. The waste water of the prewash section is after use filtered through a sieve and subsequently distillated to be reused in the cleaning section.

EP 586 470 discloses a processing system including (a) a wash-out section where unexposed areas of the plate are removed; (b) a rinse section; (c) an excess water-removing section; (d) a light-finishing section where the plate is exposed by UV light to reduce the stickiness of the plate surface; and (e) a drying section.

EP 4 067 997 provides a treatment device including a developing portion for processing flexographic printing plates, a rinsing portion for rinsing the processed printing plate and a developer storage tank which stores both the developer liquid used for development and the rinsing liquid used for rinsing. These liquids are then repeatedly used to perform development.

WO2021/224342 discloses an apparatus for treating a relief printing plate precursor with a liquid comprising a treatment compartment with treatment means configured to treat the precursor with the liquid and to remove pieces from the precursor; and a liquid collection system configured to receive the liquid and the removed pieces from the treatment means and allow at least some of said separated pieces to be dissolved in the liquid.

EP 586 483 discloses a method for processing printing plates including a continuous flow of fresh washout liquid without re-using the same liquid in a closed-loop system until the liquid becomes unacceptably dirty.

Despite the solutions provided in the art, there remains a need for a more sustainable processing method for flexographic printing plates that enables processing a larger number of defect free printing plates before it is necessary to replace filters and/or used processing solution.

### Summary of invention

It is therefore an object of the present invention to provide a sustainable processing apparatus and method for processing a photosensitive flexographic printing plate precursor with a processing solution (also referred to as developing or clean-out solution), preferably an aqueous processing solution, which highly improves the cleaning efficiency and thereby enables to reduce the consumption of said processing solution and also the amount of waste liquids such as processing and/or rinse solution generated during the processing step.

This object is realised by the processing apparatus and processing method defined in the independent claims, with preferred embodiments defined in the dependent claims. The current invention provides an apparatus and method for processing a flexographic printing plate precursor including a novel and improved filter system which allows continuous processing of said plate precursor by re-using used processing solution without requiring frequent user intervention to replace clogged filter material. Moreover, the method and apparatus of the present invention ensure a durable and more precise and accurate cleaning of the printing plate.

The filter system of the current invention includes a first and second tank (also referred to as first and second collection tank) and a third tank (also referred to as third rinsing tank) for holding the developing solution and wherein the second collection tank and the third rinsing tank both include a filter. Furthermore, the three tanks are configured in a way that the developing solution can overflow from the first collection tank into the second collection and from the second collection tank into the third rinsing tank. Preferably, the developing solution of the first collection tank overflows into the filter of the second collection tank and the developing solution of the second collection tank overflows into the filter of the third rinsing tank. As a result of this cascade configuration, the amount of washed out photopolymer resin present in the solution of the third rinsing tank remains low and this solution can suitably be used for rinsing the processed plate.

Therefore, the further advantage of the processing apparatus of the current invention including such a cascade configuration is that there is no separate rinsing station required. After rinsing, the used rinse solution flows back, via the collector tank and conduit, into the first collection tank whereby the tank is replenished. Without this replenishment process, the concentration of the washed out photopolymer resin in the preferably aqueous processing solution in the first collection tank and/or the second collection tank quickly builds up to an unacceptable level which detrimentally effects the performance of the processing apparatus after only processing a few photosensitive flexographic printing plates.

It has been found that an acceptable performance can be maintained even after processing a large number (the amount depends on the specific flexographic printing plate, the temperature of the processing solution, the amount of cleaning cycles etc and can for example be more than 10, preferably more than 20 or even more than 50 printing plates) of flexographic photosensitive printing plates using the cascade/filter system of the current invention. Also, the volume of the solution required to rinse the photosensitive flexographic printing plate may be significantly reduced.

A preferred embodiment of a processing apparatus which highly contributes to the reduction of waste liquids is described in more detail below.

### Brief description of the drawings

FIG. 1 is a schematic representation of a preferred embodiment of the processing apparatus of the present invention.
FIG. 2 is a schematic representation of a preferred embodiment of the cascade/filter system shown as it is filled with developer solution.
FIG. 3 is a schematic representation of a preferred embodiment of a moveable structure including a flat support and a mounting system including brushes embedded on a support.

The numbers in the Figures refer to the following features of a preferred apparatus according to the present invention :
1 Processing unit
2 Mechanical cleaning system
3 Brushes
4 Moving belt
4a Front side of the processing apparatus
4b End side of the processing apparatus
5 Conduit
6 Collector tank
7 First collection tank
8 First Pump
9 Second collection tank
10 First Filter
11 Second Pump
12 Third rinsing tank
13 Second Filter
14 Third Pump
15 Small Chamber
16 Water supply
17 Mounting system
18 Adjusting screws
R1 to R4 Heating elements
T1 and T2 Sensors for temperature
L1 to L4 Level sensors

### Detailed description of the invention

The photosensitive flexographic printing plate precursor

The photosensitive flexographic printing plate precursors, also referred to as relief-forming precursors, typically contain a UV sensitive layer (also referred to as photopolymerizable layer, photocurable or relief-image forming layer) on a dimensionally stable support and may form a latent image upon UV exposure. The printing plate precursors can be positive- or negative-working, but are typically negative-working. In negative-working printing plate precursors, the non-exposed areas of the coating dissolve in the processing solution while the exposed areas remain resistant and a relief image is formed.

Many methods for making relief images are known in the graphic arts. Photosensitive materials comprising an ablatable or mask layer on the surface of a photosensitive layer, a so-called "integral mask" or "in-situ mask" may be used for preparing a relief image without the use of a photographic negative or separate masking elements. These photosensitive materials are formed into relief images by first image-wise exposing the mask layer with laser radiation to selectively remove the layer in the exposed areas, i.e. forming a mask, followed by overall exposure with actinic radiation to cure the photosensitive layer in the unmasked areas. Alternative methods include making an article bearing a relief image by first forming a mask image on a base material, for example by thermally imaging a suitable mask film or masking element to provide the desired pattern (generally using an infrared radiation laser under computer control), followed by transferring the mask image to a photosensitive material, and exposing the photosensitive material to a curing radiation, typically ultraviolet radiation. More details concerning a mask film is described in the unpublished patent application EP23185990.1 [0044] to [0065].

The latent image includes exposed portions where the photopolymer resin has been hardened by exposure to appropriate actinic radiation and unexposed portions where the photopolymer resin remains soft and has to be removed from the substrate during processing. The processing unit is used to develop the latent image into a relief image by removing the unexposed portions of the photopolymer layer from the photosensitive flexographic printing plate -also referred to herein as washed out photopolymer resin, followed by a rinsing step to remove any potential dirt or debris that may be present on the surface of the developed photosensitive flexographic printing plate.

After processing, the flexographic printing plate is preferably dried to remove any excess solvent, for example, the relief image can be blotted or wiped dry, or dried in a forced air or infrared oven, for example during 1-4 hours at 45 °C- 65 °C for solvent developed plates and for example 10 min for water developed plates. Optimal drying times and temperatures can be defined by the person skilled in the art.

The imaged relief-forming precursor may be post-cured by exposing the relief image to curing radiation to cause further hardening or crosslinking.

Post-curing can be carried out using the same type of UV-radiation previously used to expose the relief-forming precursor through the imaged mask material or for example exposure to radiation having a wavelength not higher than 300nm.

Detackification also known as light finishing can be performed if the relief image surface is tacky. Such treatments, for example, by treatment with bromide or chlorine solutions or exposure to UV or visible radiation, are well known to by the person skilled in the art.

Suitable supports include dimensionally stable polymeric films and aluminum sheets. Polyester films are particularly useful. Optionally the support may be coated with additional layers e.g. an adhesion improving layer.

The support is typically about 20 - 200 microns thick. Optionally, the support may be pretreated in order to modify its wettability and/or adhesion behaviour to subsequently applied coatings. Such surface treatments include corona discharge treatment, application of a subbing layer, a release layer and/or an adhesive layer such as an acrylic or vinyl acetate adhesive.

The photopolymerizable layer of the relief-forming precursor preferably comprises an elastomeric binder and a UV curable composition that can be cured or hardened by mainly polymerization and/or crosslinking upon exposure to UV radiation. The UV curable composition preferably comprises polymerizable or photocurable monomer(s) and at least one photoinitiator.

Suitable polymerizable monomers include ethylenically unsaturated polymerizable compounds having relatively low molecular weight (generally less than 30,000 Daltons) such as for example polymerizable monomers including various mono- and polyacrylates, acrylate derivatives of isocyanates, esters, and epoxides. Specific suitable monomers include, but are not limited to t-butyl acrylate, lauryl acrylate, the acrylate and methacrylate mono- and polyesters of alcohols and polyols such as alkanols, e. g. , 1, 4-butanediol diacrylate, 2, 2, 4-trimethyl-1, 3 pentanediol dimethacrylate, and 2, 2-dimethylolpropane diacrylate, alkylene glycols, e.g. , tripropylene glycol diacrylate, butylene glycol dimethacrylate, hexamethylene glycol diacrylate, and hexamethylene glycol dimethacrylate, trimethylol propane, ethoxylated trimethylol propane, pentaerythritol, e. g. pentaerythritol triacrylate, dipentaerythritol, and the like. Other examples of suitable monomers include acrylate and methacrylate derivatives of isocyanates, esters, epoxides and the like, such as decamethylene glycol diacrylate, 2, 2-di(phydroxyphenyl)propane diacrylate, 2, 2-di(phydroxyphenyl) propane dimethacrylate, polyoxyethyl-2, 2-di(phydroxyphenyl) propane dimethacrylate, and 1-phenyl ethylene-1, 2-dimethacrylate. The typical amount of one or more polymerizable monomers in the UV-sensitive layer is at least 5 weight % and up to and including 25 weight %, based on total dry weight of the UV-sensitive layer.

The photoinitiator can be a single compound or combination of compounds that are sensitive to UV radiation and that generate free radicals that initiate the polymerization of the polymerizable monomer(s) without excessive termination. They are preferably present in an amount of about 0.001 weight % and up to and including 10 weight % based on the total dry weight of the UV sensitive layer. Examples of suitable photoinitiators include but are not limited to optionally substituted polynuclear quinones, vicinal ketaldonyl alcohols, alphahydrocarbonsubstituted aromatic acyloins, dyes of the phenazine, oxazine, and quinone classes and cyclohexadienone compounds.

The elastomeric binder preferably comprises polymers or resins that are preferably soluble, swellable or dispersible in aqueous, semi-aqueous, or organic solvent developers. Suitable examples include, but are not limited to, natural or synthetic polymers of conjugated diolefin hydrocarbons including polyisoprene, 1, 2-polybutadiene, 1, 4-polybutadiene, butadiene/acrylonitrile, block copolymers such as for example butadiene/styrene thermoplastic-elastomeric block copolymers, coreshell microgels, and blends of microgels and preformed macromolecular polymers. The elastomeric binder can comprise at least 65 weight % and up to and including 90 weight %, based on total dry UV-sensitive layer weight. The UV-sensitive layer may include other compounds that provide various properties including but not limited to sensitizers, plasticizers, rheology modifiers, thermal polymerization inhibitors, tackifiers, colorants, antioxidants, anti-ozonants, and fillers; in amounts that are known in the art. Examples of suitable plasticizers include aliphatic hydrocarbon oils, e. g. naphthenic and paralfinic oils, liquid polydienes such as liquid polybutadiene, liquid polyisoprene. Generally, plasticizers are liquids having molecular weights of less than about 5.000 Daltons, but can have molecular weights up to about 30.000 Daltons.

The thickness of the UV-sensitive layer is preferably at least 500 µm and up to and including 6400 µm in average dry thickness.

The relief-forming precursor may be protected against mechanical damage by for example a removable protective or cover film or sheet located on the uppermost layer. Useful cover sheets include flexible polymeric films, e.g., polystyrene, polyethylene, polypropylene, polycarbonate, fluoropolymers, polyamide or polyesters. Preferably polyesters are used, especially polyethylene terephthalate.

### The processing apparatus

The present invention provides a processing apparatus which is especially designed for performing the processing of a flexographic printing plate precursor. The Figures represent a highly preferred embodiment of the main parts of such a processing apparatus.

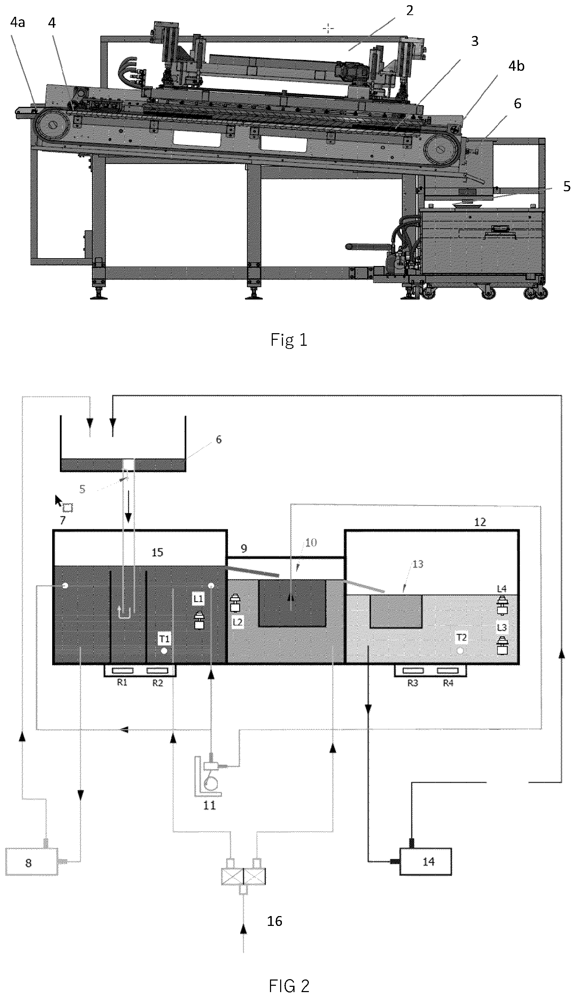

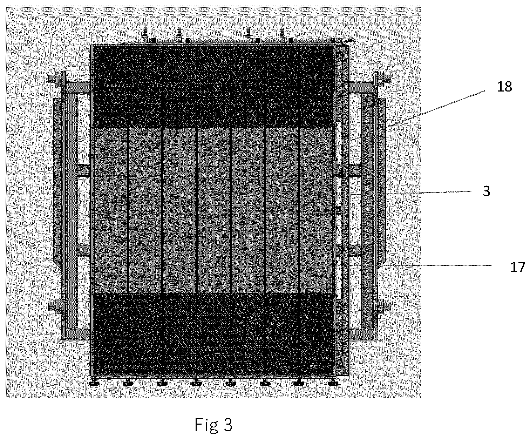

The processing apparatus for processing a photosensitive flexographic printing plate precursor having a latent image comprises:
- a processing unit (Fig 1, 1) - for developing the latent image into a relief image - comprising (i) a mechanical cleaning system (Fig 1, 2) including one or more brushes (Fig 1, 3) which can contact the photosensitive flexographic printing plate precursor; and (ii) a conduit (Fig 1 and 2, 5) for returning used processing solution containing the removed photopolymer resin from a collector tank (Fig 1 and 2, 6) present in the processing unit back into a first collection tank (Fig 2, 7);
- a first collection tank (Fig 2, 7) for holding a processing solution; a first pump (Fig 2, 8) for supplying processing solution from the first collection tank to the mechanical cleaning system including one or more brushes;
- a second collection tank (Fig 2, 9) for holding a processing solution including a first filter (Fig 2, 10) and a second pump (Fig 2, 11) for pumping processing solution from the second collection tank and bringing it into the first collection tank, and
- a third tank, further referred to as "third rinsing tank" (Fig 2, 12)
   - for holding processing solution to rinse the developed relief image in order to remove potential debris (for example remaining removed photopolymer resin) from the developed relief image - including a second filter (Fig 2, 13), and a third pump (Fig 2, 14) for supplying the processing solution present in the third tank to the relief image on the photosensitive flexographic printing plate.

Well known features which are preferably present but not shown in the Figures include and or not limited to a feeder for delivering printing plates to the processing unit (see below); supply tanks comprising fresh processing solution, water and/or one or more replenishing solutions; waste collector tanks wherein exhausted processing solution can be drained; sensors to detect the level of solution in the different tanks; and other conventional parts.

The processing solution from the first collection tank flows - i.e. cascades -into the second collection tank, preferably into the filter of second collection tank thereby maintaining the volume of the processing solution in the first collection tank below a predefined maximum volume, and the processing solution from the second collection tank flows into the third rinsing tank, preferably the filter of the third rinsing tank, thereby maintaining the volume of the processing solution in the second collection tank below a predefined maximum volume. As a result of this cascade configuration, the level in the three tanks remains approximately constant. Optionally, processing solution can be added to for example the first and/or second collection tank in order to compensate for possible evaporation of the processing solution during the cleaning step. The level in the tanks can preferably be monitored by means of level detectors.

The liquid in the first collection tank may be pulsed in order to at least partly prevent the removed photopolymer resin - i.e. washed out photopolymer resin - from clumping together.

The processing solution present in the first collection tank for developing the flexographic printing plate is provided to the mechanical cleaning system (Fig 1, 2) present in the processing unit by means of at least one pump. The mechanical cleaning system aids the removal of the unexposed photopolymer resin from the flexographic printing plate precursor and typically includes one or more preferably flat brushes (Fig 1, 3) which may be free-standing but are preferably embedded on a support. Various brush configurations can be used, for example, the brushes can be downward facing or upward facing; preferably the brushes are downward facing. The brushes preferably move relative to the photosensitive flexographic printing plate, for example in a side-to-side motion and/or a circular motion and/or an elliptical motion and contact the photopolymer layer of the photosensitive printing plate precursor while it is provided with the processing solution. The direction of these motions (i.e. cleaning cycles) preferably alternates between clockwise and counterclockwise. Processing solution can be directed through a spray bar situated in the vicinity of the bristles of the brush(es) whilst the plate is being brushed, or processing solution can be provided to the brushes via inlets present on the brushes. Preferably, during the cleaning cycles - also referred to as development cycles or processing cycles - the printing plate precursor is slightly moved forward and backward in order to avoid the formation of patterns such as for example circles. This movement can be achieved by for example slightly moving forward and backward a movable belt onto which the printing plate precursor may be provided for entry into the processing unit (see below) during the cleaning cycles.

An important aspect during the processing is the distance of the brush bristles from the surface of the printing plate. This distance for a plate having a thickness of for example 1.14 mm will not be the optimum distance for a thicker plate to be processed. Inevitably, bristles will bend and, rather than having the required brush action, the bristles will be stroking the surface of the thicker plate. For thinner plates, the processing will be inefficient as the bristles will not reach the surface of the plate. The design of the brush(es) allow an enhanced contact area between the brush and the printing plate precursor whereby an improved cleaning behaviour can be achieved. The brush(es) are preferably present over the total width of the processing unit and are thus preferably adapted to the size of the processing unit.

The contact-pressure of the brush(es) to the printing plate precursor should be as uniform as possible all over its width in order to obtain a full and even clean out of the image areas. This can be achieved by for example adjusting optional screws present on top of the brush(es) whereby the distance of the brushes to the printing plate can be modified and individual fine tuning of the height of the brushes can be achieved. For example, in order to maintain optimal washout behaviour, bristles which are more worn out can be lowered down independently from less worn out bristles. Adjustable screws can lower down the position of the bristles per areas as small as for example 10 cm/10 cm area.

In a preferred embodiment, the pressure adjustment of the individual brushes and the uniformity within one brush is adjusted by means of multiple contact pressure points of which the pressure for each point individually can be increased or lowered to obtain uniform pressure on the plate surface. An adjustment iteration procedure is monitored by means of an exposure cycle and measurement process using a dedicated template that contains a position chart of each of the pressure points. The measuring result is captured in a template that indicates the correction areas based on a chosen uniformity tolerance. The iteration process stops when the clean out pressure uniformity complies to the chosen tolerance. The target tolerance is dictated by the industry standards and application needs.

In a preferred embodiment, about six or more strips including flat brushes are attached to a support (Fig 3) and can be provided with processing and/or rinsing solution at for example one or more inlets per strip. The processing solution and/or rinsing solution injected into these inlets via for example several supply channels and/or nozzles, becomes distributed over the full length of the strips including the flat brushes. Alternatively or in addition, the processing and/or rinsing solution can be provided to the brushes by means of a spray bar including valves and/or nozzles located above the brushes. The brushes may be cleaned before, during and/or after processing by providing processing and/or rinsing solution to the brushes when they are not in contact with the printing plate.

The strips including the flat brush(es) are preferably adapted to the size of the processing unit and present over the total width of the processing unit. Preferably, the strips have a length of 300 to 3000 mm, more preferably 500 to 2000 mm and most preferably 600 to 1600 mm and a width of 50 to 250 mm, more preferably 80 to 200 mm and most preferably 100 to 180 mm. Adjustable screws which can lower down the position of the bristles per areas as small as for example 10 cm/10 cm area are preferably present on the brushes.

The brushes are composed of a set of bristles attached to a base; the bristles are preferably independently angled 50-90 degrees, more preferably 70-85 degrees, and most preferably 80-85 degrees, relative to the base. Preferably, at least half of the sets of bristles are angled. The bristles may be flexible and/or rigid; preferably they are selected such that no damage occurs to the printing surface upon contact. The choice of the specific type of bristles is preferably adapted to the hardness and/or the thickness of the printing plate precursor to be processed; for example printing plates with a high Schore A value - e.g. about 70 or more - require relative stiff bristles while printing plate precursors with a low Schore A value - e.g. about 30 or less - require relative flexible bristles. The bristles are made of any suitable material such as for example a polyamide based synthetic fiber (e.g. NylonTM), a polyester based synthetic fiber (e. g. polyethylene terephthalate or polybutylene terephthalate), a polyacrylic synthetic fiber (e.g. polyacrylonitrile or polyalkyl-(meth)acrylate), polyvinylchloride, polyvinylidene chloride, cellulose, polyurethane, fluorinated resins (e.g. copolymers of ethylene/ethylene tetrafluoride, polyvinylidene fluoride), polystyrene, polyolefines such as polypropylene or polyethylene (e.g. HDPE) and/or natural fibres such as for example horse or boar hair, or Sisal^{™}. Most preferred, the bristles are made of Nylon^{™} or polypropylene. The bristles preferably have a bristle diameter of 10 to 50 micron, more preferably 15 to 35 micron and most preferably 18 to 25 micron. The bristle diameter is not especially restricted, but a diameter smaller than 10 micron may have inferior rubbing/brushing properties. The length of the bristles is preferably 2 to 50 mm, more preferably 4 to 25 mm and most preferably 6 to 20 mm. The length is not especially restricted but a length shorter than 3 mm may touch the printing plate precursor in a non uniform way.

The mechanical cleaning system preferably comprises a movable structure and a flat support attached to this movable structure. To this flat support - for example an aluminum plate support - a mounting system is preferably attached into which brushes embedded on a support can be conveniently inserted. The moveable structure including the flat support is preferably positioned substantially parallel or parallel to the surface of the printing plate precursor to be washed out. According to the current invention, this (substantially) parallel position relative to the printing plate precursor, is preferably obtained by means of one or more, more preferably four or more adjustment engines mounted on top of the moveable structure including the flat support. Most preferably, four adjustment engines are positioned at the four corners of the moveable structure including the flat support. This parallelism of the moveable structure including the flat support to the printing plate precursor is preferably optimized by means of a software calibration system that controls the adjustment engines.

During processing, this (substantially) parallel position is maintained while the distance of the brushes to the surface of the printing plate precursor is gradually reduced in order to remain optimal washout conditions - more accurate cleaning in terms of for example reproduction of minimal dots - and to finally obtain a printing plate containing printing areas having the desired relief characterized by both a preferably flat surface and an optimized shoulder or talud. In other words, the final brush distance is predetermined and gradually achieved during processing by gradually lowering the brushes, for example after each two or more cleaning cycles, reaching the desired final distance at the end of the cleaning process.

Several cleaning cycles are performed; the amount of cycles is determined by the skilled person and relates for example to the specific flexographic plate precursor and/or type, composition, temperature etc of the development solution. Typically, one cycle includes movement of the brushes in clockwise direction, e.g. for about 30 sec, followed by movement of the brushes in counterclockwise direction, e.g. for about 30 sec. In between the several cycles, the brushes preferably move upwards whereby the processing and/or rinsing solution is able to flow back into the collector tank of the processing unit. During processing, at least the majority of the unexposed photopolymer resin should be removed to provide the relief image. Supplementally, extra water pressure and/or vibration may be applied to the printing plate during processing of the printing plate, for example by employing ultrasonic waves or the like.

When the processing is finished, the brushes move-up and the remaining processing solution flows into the collector tank of the processing unit and returns via the conduit to the first collection tank. The used processing solution contains the major part of the photopolymer resin that was removed from the unexposed portions of the photopolymer layer. The printing plate is preferably inclined so that the processing solution on the surface of the printing plate is allowed by gravity to flow off in a direction towards the collector tank taking with it any suspended solid particles. The first collection tank preferably includes a chamber (15), preferably a small chamber, into which the used processing solution is guided by means of said conduit. The small chamber prevents excessive agitation and or foaming of the liquid in the first collection tank. Moreover, the larger particles of the wash out photopolymer resin are preferably for the most part retained in the small chamber while the rest of the used processing solution flows over into the first collection tank. As the larger particles of the wash out photopolymer resin preferably remain in the small chamber, the processing solution in the first tank may remain more clean for a longer period and thus more plate precursors can be processed. The term "small" used herein is relative to the first collection tank and is at most ¼ of the volume of the first collection tank. Preferably its volume is 5l or less, more preferably 8 l or less, most preferably 10 l or less.

Subsequently, the solution of the first collection tank partly flows into the second collection tank, preferably into the filter of the second collection tank, and the solution of the second collection tank partly flows into the third rinsing tank, preferably into the filter of the third rinsing tank. The collection and/or rinsing tanks preferably have a volume larger than 20 l, or even larger than 30 l, e.g. at least 35 l or more. The volume of the collection and/or rinsing tanks may be the same or may be different.

Preferably, the first and/or second collection tanks and/or third rinsing tank comprise a heating means for heating the processing solution, more preferably the first collection tank and the third rinsing tank comprise a heating means. The temperature of the processing solution in the tanks including a heating means is preferably between 30° C and 60° C, more preferably between 35° C and 55° C and most preferably between 40° C and 50° C. Preferably, the heating means comprise at least one heating element such as for example an immersion heater for immersion into the processing solution, an induction heating element, a heating foil or a heat pad such as a ceramic- or silicone-based heat pad. The latter heating elements may be affixed to a wall of the tanks, e.g. to an outer wall of the tank. By keeping the temperature of the processing solution constant during its use, the effectiveness of the washout step may be significantly improved. Preferably, the collection and/or rinsing tanks are formed of plastics material (e.g. polyvinylchloride, polycarbonate, polypropylene and/or polybutylene terephthalate) or metal (e.g. aluminium or stainless steel). Most preferably, the collection tanks are formed of stainless steel as this is an excellent conductor of heat and therefore ideal for use with the at least one heating elements described above, preferably a plurality of heating elements. Furthermore, since stainless steel is rustproof, it has a long service life.

The filters preferably present in respectively the second collection tank and the third rinsing tank are preferably removable filter bags including a coarse fabric filter material having for example a pore size of (5 to 150 micron), more preferably a pore size of 80 to 120 micron, most preferably about 100 micron. The optional filters in the second collection tank and third rinsing tank may be similar; more preferably, the filter in the third rinsing tank has a smaller pore size. Alternatively, a charcoal filter housed in a cartridge or canister or a filter including stainless steel sieves - a metal screen - with sizes for example selected between 5 and 200 micron or 70 and 200 microns, may be used. Preferably, the filter material is configured to hold back pieces having a largest dimension larger than 5 mm, preferably larger than 3 mm, more preferably larger than 0.5 mm.

A curtain of air bubbles is preferably provided at the surface of the filter in the second collection tank and/or the filter in the rinsing tank in order to reduce and/or prevent clogging of the sieves. Alternatively, providing ultrasonic movements in the filter may reduce and/or prevent clogging of the sieves. Both techniques may be applied at the same time.

In a special embodiment, a filter aid may be used - i.e. a substance containing solid particles that builds up a porous, permeable and rigid lattice structure - a filter cake - that can retain solid particles. The metal screen or fabric filter material may serve as a support for the filter cake whereby a porous layer is formed on the surface of the screen or fabric filter. The porous layer is preferably composed of irregularly shaped particles which interlace and overlay forming many open spaces. The size of these openings is so small that the unwanted solid particles are retained form the liquid while the high number of openings compensate for their small sizes resulting in a relative fast flow. After processing several flexographic printing plates, the filter cake is preferably removed from the filter and the filter may be reused.

In a special embodiment, an external filter such as for example a rotary filter including a precoat, may be connected to one of the collection/rinsing tanks or an external extra buffer tank, preferably to the first and/or second collection tank, such as for example disclosed in WO2023/0086975 where a coating unit for coating the rotary filter with the precoat is also described. By this extra filtration of the processing solution, it can be used for a longer time, i.e. the lifetime of the processing solution is prolonged and more printing plates can be processed. Moreover, the waste that is generated by using such a filtration system is solid and can be easily separated and/or discharged, or even re-used in production of other articles, which contributes to a circular economy.

Optionally, the rinsing tank may include an extra external filter such as for example a charcoal, cartridge or millipore filter.

After processing the printing plate precursor, some dirt or debris may remain on the surface of the relief image. This debris is primarily made up of residual particles of photopolymer resin that were not washed off the surface of the printing plate precursor during the cleaning cycles. In order to remove the most part, preferable all, of this potential remaining debris, the processing preferably includes an extra step, i.e. the developed relief image is rinsed using processing solution supplied from the third rinsing tank. Preferably, at least one pump is used to direct this solution onto the printing plate, for example by means of the mechanical cleaning system including the brush(es) described above or more preferably by means of at least one spray bar including nozzles which spans the width of the printing plate and travels over its surface. After the rinsing step, the used solution flows into the collector tank of the processing unit, and from there, via the conduit, into the small chamber of the first collection tank. Optionally, the at least one spray bar and/or an optional additional spray bar can be provided with fresh processing solution e.g. supplied from an extra tank and/or from a tap providing tap water.

Finally, after processing the printing plate is preferably dried for example by using an air knife to direct a stream of air, preferably hot air, onto the surface of the developed relief image, preferably under pressure. Subsequently, the dried photosensitive flexographic printing plate is preferably post exposed in a conventional UV exposure and finishing process. The drying process and/or post treatment process may independently be carried out in the processing apparatus or in a separate device or in both the processing apparatus and a separate device.

The above described processing may be optimised and/or automated. For example, before, after and during the cleaning cycles with processing solution form the first collection tank and rinsing using processing solution from the third rinsing tank, an extra cleaning step may be performed using liquid from an external tank and/or using water from a tap; and/or the brushes may be cleaned for example by providing processing solution by means of the spray bars described above, and/or the printing plate may be dried by means of hot air, or other sequences may be selected in order to optimise the processing of the printing plate precursors. The specific sequence of the cleaning cycles is preferably optimised for each type of printing plate precursor and may include up to seven or more steps.

The processing solution is preferably water-based and typically includes at least one active ingredient such as a dispersing agent or a surfactant to aid the removal of the unexposed areas. Aqueous processing solutions are generally preferred above processing solutions including solvents e.g. organic solvents because of their environmentally friendly characteristics. Any appropriate dispersing agent or surfactant known in the art can be used, for example a salt of a fatty acid, saturated or unsaturated, preferably having an average carbon number in the range of 10-20, a sulphonate such as an alkylbenzene sulphonate having an average carbon number in the range of 8-16, or an alfa- olefin sulphonate having an average carbon number in the range of 10-20, a phosphonate, polycarboxylic acids, buffers, etc. Widely available commercial dishwashing powder, hand soaps, tablets or the like are suitably used. The aqueous processing solution preferably operates optimally within a defined pH range, for example between 8 and 12, more preferably between 9 and 11.5 and most preferably between 10 and 11. The pH may be monitored and/or adjusted during processing of the printing plate precursor.

The processing unit preferably includes a moving belt (Fig 1, 4) - e.g. a transport belt arranged in a continuous loop onto which the photosensitive flexographic printing plate precursor can be positioned for loading/unloading into/out of the processing unit of the processing apparatus. The unloading of the printing plate precursor may take place at the same side of the processing apparatus as the loading side, or alternatively, may take place at the opposite side of the processing apparatus as the loading side, which means the printing plate travels through the processing apparatus. The moving belt preferably has a surface which secures the plate in a stationary manner relative to the moving belt as the printing plate precursor is fed into the processing unit, e.g. a surface having a low surface roughness such as natural rubber, and/or a sticky surface. Alternatively, the plate may be secured to the moving belt in a stationary manner relative to the moving belt by providing on the surface of the moving belt a layer including a sticky substance that causes the plate to adhere to the belt. The moving belt including a sticky surface or the sticky layer provided on the moving belt may for example be a substance manufactured from pressure sensitive adhesive plastics or rubber sheets having a naturally sticky surface. The belt may comprise more than one layer; for example, a plate carrying layer and a flexible backing material.

The word "sticky" refers to an adhesive quality that allows temporarily attachment of the printing plate precursor to such a surface without leaving a residue. This type of stickiness of the moving belt allows repositioning, meaning you can easily remove and reattach a printing plate precursor multiple times. Besides the natural rubber and/or the rubber having a low surface roughness, suitable examples are pressure-sensitive adhesives (PSA) which are capable of forming a bond when light pressure is applied without requiring water, heat, solvent and the like to activate the adhesive, such as for example synthetic rubbers - such as styrene-butadiene or styrene-isoprene-styrene -, acrylic adhesives, polyvinyl acetate adhesives, cyanoacrylate adhesives, thermoplastic adhesives, polyurethane adhesives, epoxy adhesives or silicone adhesives, optionally including tackifiers (low molecular weight compounds such as rosin esters or hydrocarbon resins).

After processing, the printing plate is unloaded onto for example a movable table positioned at the end of the moving belt. Also, the printing plate may be removed from the moving belt manually by an operator or by a device capable of lifting the plate away from the belt. The device capable of lifting the plate away from the belt preferably has a profile shaped like a knife or a wedge which is insertable between the plate and the belt. The device may be inserted between the plate and the belt by the forward motion of the printing plate towards the device.

Transporting the printing plate precursor in the processing unit by means of a moving belt allows larger and/or heavier plates to be more easily processed, for example, plates having a dimension (e.g. 900 mm x 1000 mm or larger) and/or thicker plates (e.g. 3.94 mm or larger) Moreover, the travelling speed of the printing plate precursor in and/or out of the processing unit can be optimized and/or finetuned.

The printing plate precursor may be in a horizontal position or may be inclined. When the printing plate precursor is positioned on the moving belt, it may be inclined by for example providing an inclined support on the moving belt whereby the processing solution on the surface of the printing plate precursor is allowed by gravity to flow off from the surface of the printing plate in a direction towards the collector tank preferably taking with it any suspended, washed out solid particles. This allows solid particles and/or debris to be more effectively removed from the surface of the printing plate thereby providing a more accurate printing surface. Alternatively, the moving belt itself is configured so that the side of the moving belt where the printing plate precursor enters the processing apparatus (Fig 1, 4a, front side) is raised relative to the opposite side or end of the moving belt (Fig 1, 4b, end side) whereby the printing plate is inclined downwards and processing and/or rinsing fluid in contact with the printing plate precursor is encouraged to drain off from the front side and/or the back side of the plate into the collector tank. Preferably the angle of inclination of the plate, and/or the belt and/or any support for the plate is 1-25° , more preferably 1-15° , most preferably 1-10 ° or 1 to 6° from the horizontal position.

Alternatively, although less preferred, the exposed flexographic printing plate may travel into the processing unit on a flat bed, for example a table top, above which a brush head can be raised or lowered according to the entering plate thickness, thus offering optimum bristle distance and wash out action.

### The processing method

The present invention also provides a processing method for processing a photosensitive flexographic printing plate precursor having a latent image comprising the steps of treating the printing plate precursor in the processing apparatus as described above with a processing solution provided from the first collection tank followed by treating the printing plate precursor with the processing solution provided from the third rinsing tank. The photopolymer resin is preferably aqueous-processable and the processing solution is preferably an aqueous solution as described above.

## Claims

1. A processing apparatus for processing a photosensitive flexographic printing plate precursor having a latent image comprising:
- a processing unit, for developing the latent image into a relief image including (i) a mechanical cleaning system including one or more brushes and (ii) a conduit (Fig 1 and 2, 5) for returning used processing solution from a collector tank (Fig 1 and 2, 6) into a first collection tank (Fig 2, 7);
- a first collection tank (Fig 2, 7) for holding processing solution; a first pump (Fig 2, 8) for supplying processing solution from the first collection tank to the printing plate precursor;
- a second collection tank (Fig 2, 9) for holding processing solution including a first filter (Fig 2, 10) and a second pump (Fig 2, 11) for pumping up processing solution from the second collection tank and bringing it into the first collection tank, and
- a third rinsing tank (Fig 2, 12) for holding processing solution to rinse the developed relief image including a second filter (Fig 2, 13) and a third pump (Fig 2, 14) for supplying the solution present in the third tank to the printing plate precursor;
and wherein the first, second and third tanks are connected by a cascade configuration which allows an overflow of the processing solution from the first collection tank into the second collection tank and the processing solution from the second collection tank into the third rinsing tank.

2. A processing apparatus according to claim 1 wherein the volume of the processing solution in the first collection tank and the second collection tank remains below a predefined maximum volume.

3. A processing apparatus according to claims 1 or 2 wherein the processing solution in the first collection tank is pulsed.

4. A processing apparatus according to any of the preceding claims which includes a moving belt onto which the photosensitive flexographic printing plate precursor can be positioned for loading it into the processing unit.

5. A processing apparatus according to claim 4 wherein the moving belt is configured so that the side of the moving belt where the printing plate precursor enters the processing apparatus (Fig 1, 4a) is raised relative to the opposite side or end of the moving belt (Fig 1, 4b) whereby the printing plate precursor is inclined downwards.

6. A processing apparatus according to claims 4 or 5 wherein the moving belt includes a rubber sheet having a naturally sticky surface.

7. A processing apparatus according to claims 4 to 6 wherein the moving belt includes a layer including a sticky substance manufactured from pressure sensitive adhesive plastic.

8. A processing apparatus according to any of the preceding claims wherein the mechanical cleaning system comprises
- a movable structure and
- a flat support attached to this movable structure which comprises a mounting system into which brushes embedded on a support can be inserted.

9. A processing apparatus according to claim 8 wherein the flat support is positioned substantially parallel to the surface of the photosensitive flexographic printing plate precursor.

10. A processing apparatus according to claim 9 wherein the movable structure includes four adjustment engines at its corners to obtain the substantially parallel position relative to the surface of the photosensitive flexographic printing plate precursor.

11. A processing apparatus according to any of the preceding claims wherein the first collection tank includes a chamber for reducing agitation and/or foaming of the used processing solution.

12. A processing apparatus according to any of the preceding claims wherein a curtain of air bubbles and/or ultrasonic movements are provided at the surface of the first filter in the second collection tank and/or the second filter in the rinsing tank.

13. A processing apparatus according to any of the preceding claims wherein an external rotary filter including a precoat is connected to the first and/or second collection tank.

14. A processing apparatus according to any of the preceding claims wherein a predetermined optimal brush distance can be gradually achieved during processing of the photosensitive flexographic printing plate precursor.

15. A method for processing a photosensitive flexographic printing plate precursor having a latent image comprising the steps of treating the printing plate precursor in the processing apparatus as defined in claims 1 to 14 with processing solution provided from the first collection tank; followed by treating with processing solution provided from the third rinsing tank.

16. A method according to claim 15 wherein the printing plate precursor moves backward and forward during processing of the printing plate precursor.
